# EUROPEAN PATENT APPLICATION

(11) **EP 2 124 344 A1**
(43) Date of publication of application: **25.11.2009**
(21) Application number: 08305147.4
(22) Date of filing: 05.05.2008
(51) Int. Cl.: H03M 13/29, H03M 13/35, H03M 13/25, H03M 13/11

(54) **Coded modulation with parallel concatenated Gallager codes**

(71) Applicant: THOMSON LICENSING, 92100 Boulogne-Billancourt (FR)
(72) Inventor: Zhou, Wei, Hai Dian District 100086 Beijing (CN); Zou, Li, Hai Dian District 100088 Beijing (CN)
(74) Representative: Ruellan-Lemonnier, Brigitte

(57) **Abstract**

A parallel concatenated gallager code encoder provides at least one data bit, a first parity bit and a second parity bit, where the first parity bit is associated with a low density parity check code having a higher error correcting capability than a low density parity check code associated with the second parity bit; a modulator provides a modulated signal using a symbol constellation having at least eight symbols, each symbol associated with at least three bits, where at least one of the three bits has less reliability than the remaining bits; and a mapper maps the at least one data bit to those bit positions of a symbol having higher reliability than the at least one bit position having less reliability and maps the second parity bit to the at least one bit position having less reliability.

## Description

### BACKGROUND OF THE INVENTION

The present invention generally relates to communications systems and, more particularly, to a receiver.

Low-density parity-check (LDPC) codes were first introduced by R. G. Gallager (e.g., see Gallager, R. G., Low Density Parity Check Codes, Monograph, M.I.T. Press, 1963) as a family of block codes characterized by a sparse parity-check matrix, with each row in the matrix representing a coefficient in a parity-check equation. R. G. Gallager showed that random LDPC codes are asymptotically good for binary symmetric channels (BSC) and that they achieve small error probabilities for rates bounded away from zero as the block length increases. Compared to Turbo codes, which have a high error floor, LDPC codes usually have a low error floor, i.e., for an increase in the number of iterations there is a relatively low bit error rate (BER). As such, many communication standards adopt LDPC for channel coding. However, good performance of LDPC codes usually requires a long code length, which leads to long data delay and increased decoding complexity.

In this regard, the use of Parallel Concatenated Gallager Codes (PCGC) in LDPC coding has been proposed in order to reduce the data delay and decoding complexity of LDPC codes. This sort of LDPC coding uses good LDPC codes in the well known turbo code structure to break the fairly complex encoding and decoding of a long code into steps.

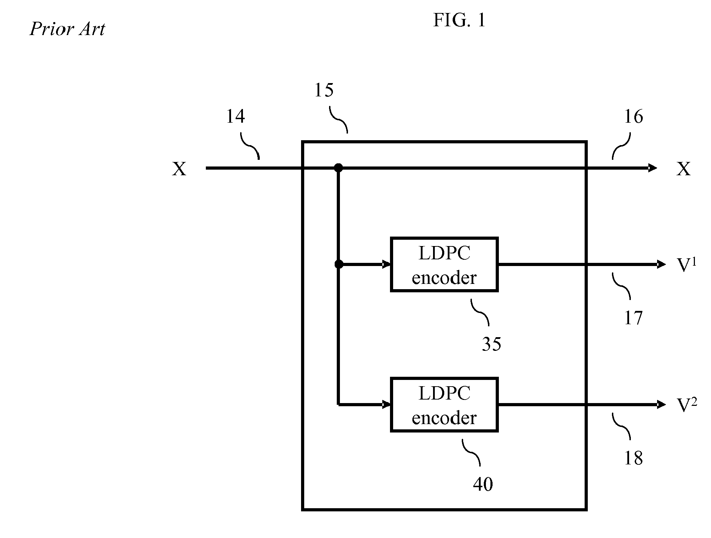

An example of a prior art PCGC encoder 15 is shown in FIG. 1. The parameter X (14) represents the systemic information bits, i.e., the data to be LDPC encoded. This data is applied to PCGC encoder 15, which comprises a number of LDPC encoders arranged in parallel, as represented by a first LDPC encoder 35 and a second LDPC encoder 40. The first LDPC encoder 35 generates parity bits V¹ (17) and the second LDPC encoder 40 generates parity bits V² (18). As such, the output of PCGC encoder 15 is the systemic information bits X (16), and parity bits V¹ (17) and V² (18).

In the arrangement shown in FIG. 1, an interleaver is not used between the two LDPC encoders. The two LDPC encoders implement different LDPC codes having different error performance. The LDPC code implemented by the first LDPC encoder 35 has better error performance than that of the LDPC coded implemented by the second LDPC encoder 40 at a low Energy per bit to noise power spectral density ratio (*Eb*/*N0*). The *Eb*/*N0* is a normalized signal-to-noise ratio (SNR), also known as the SNR per bit. However, at a high *Eb*/*N0*, the LDPC code implemented by the second LDPC encoder 40 has better decoding convergence and performs better than the LDPC code of LDPC encoder 35 due to the smaller undetected errors. In other words, each component LDPC code of PCGC encoder 15 has a different Mean Column Weight (MCW) to get different channel coding gains.

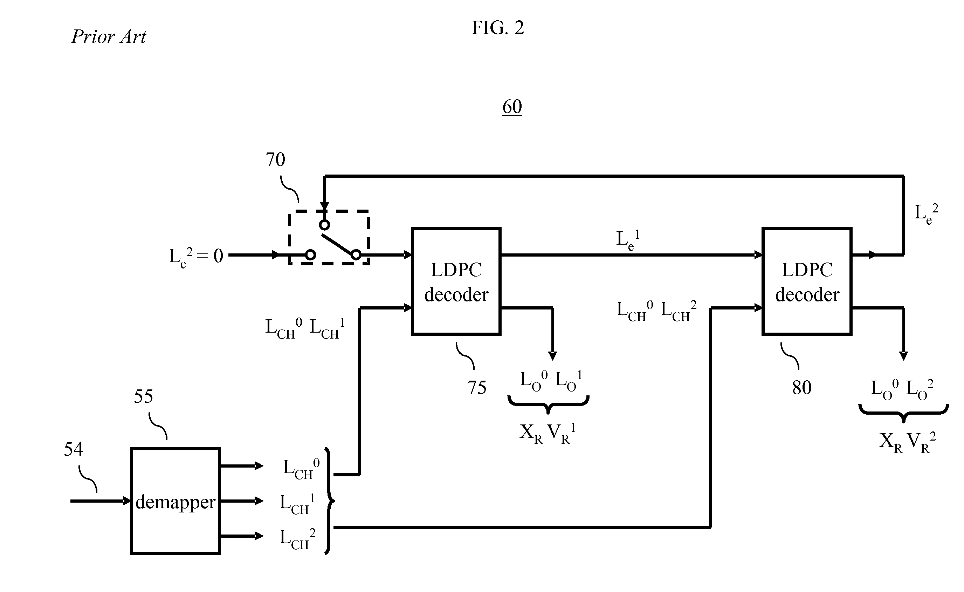

A prior art PCGC decoder 60 is shown in FIG. 2. In a complementary fashion to PCGC encoder 15 of FIG. 1, PCGC decoder 60 comprises a first LDPC decoder 75 and a second LDPC decoder 80. Also shown in FIG. 2 is demapper 55, which processes a received signal 54 to provide received versions of X, V¹ and V² as represented by LLR (log likelihood ratios) L_{CH}⁰, L_{CH}¹ and L_{CH}², respectively. As known in the art, demapper 55 makes hard decisions as to the received symbol, i.e., selecting that constellation symbol that is closest in Euclidean distance to the received signal point. First LDPC decoder 75 processes L_{CH}⁰ and L_{CH}¹ and the second LDPC decoder 80 processes L_{CH}⁰ and L_{CH}². A super iteration is defined as the process of exchanging information between the two LDPC decoders. In each super iteration, each component decoder performs a number of local iterations before passing any information to the other component decoder. In the first super iteration, LDPC decoder 75 computes the a posteriori LLR (log likelihood ratio) value Lₑ¹ of the corresponding coded bits using received sequences L_{CH}⁰ and L_{CH}¹ with no a priori information since the information bits are equally likely to be a -1 or a 1. This is represented in FIG. 2 by switch 70 being set to a value of Lₑ²=0. The second LDPC decoder 80 then computes the a posteriori probability LLR value Lₑ² using the received sequences L_{CH}⁰ and L_{CH}² along with the extrinsic information Lₑ¹ available from the first decoder, as a priori information. On subsequent iterations, the first LDPC decoder 75 uses the extrinsic information generated by the second LDPC decoder 8 0, i.e., Lₑ² (via switch 70), as a priori information to compute the a posteriori LLR value Lₑ¹. The process of exchanging information between the component decoders continues until both decoders converge to valid codewords, or a maximum number of super iterations is reached. LDPC decoder 75 provides output signals Lₒ⁰ and Lₒ¹, representative of error corrected received versions of systematic information bits, X_{R} and parity bit V_{R}¹, respectively; and LDPC decoder 80 provides output signals Lₒ⁰ and Lₒ², representative of error corrected received versions of systematic information bits, X_{R} and parity bit V_{R}², respectively. As is known in the art, the two component LDPC decoders both provide the systematic information bits, X_{R}. However, should the value for X_{R} provided by LDPC decoder 80 be different from the value for X_{R} provided by LDPC decoder 75, the value for X_{R} from LDPC decoder 75 is only used since LDPC decoder 75 is associated with the LDPC code having more error-correcting capability.

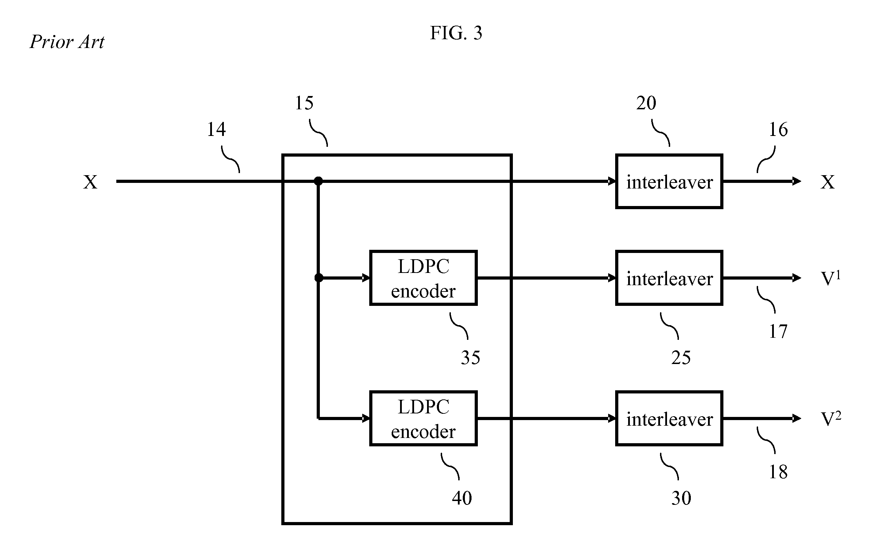

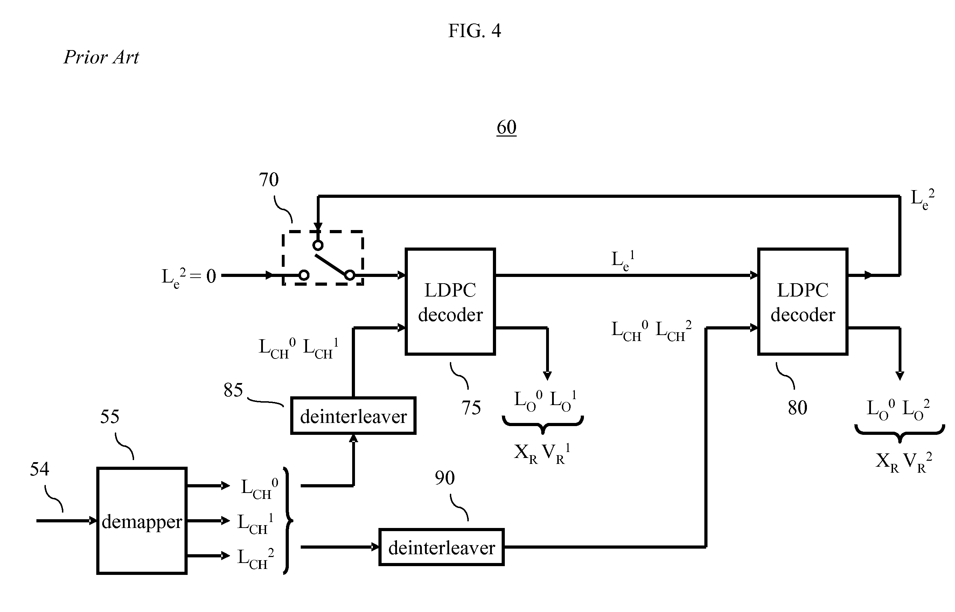

Turning briefly to FIGs. 3 and 4, these figures show prior art arrangements of a PCGC encoder and a PCGC decoder using interleavers. The arrangement shown in FIG. 3 is similar to the arrangement shown in FIG. 1, except that interleavers 20, 25 and 30 now interleave the respective output signals of PCGC encoder 15 as shown before providing the output signals: systemic information bits X (16), and parity bits V¹ (17) and V² (18). Likewise, the arrangement shown in FIG. 4 is similar to the arrangement shown in FIG. 2 except that deinterleavers 85 and 90 now deinterleave the respective LLR signals from demapper 55 as shown during the decoding process.

### SUMMARY OF THE INVENTION

Since the need for more and more channel capacity is increasing in today's communications systems, the design of a channel code is often required to use a high order modulation. We have observed that one can match PCGC LDPC coding to a higher order modulation and get very good performance along with high spectrum efficiency.

Therefore, and in accordance with the principles of the invention, a parallel concatenated gallager code encoder provides at least one data bit, a first parity bit and a second parity bit, where the first parity bit is associated with a low density parity check code having a higher error correcting capability than a low density parity check code associated with the second parity bit; a modulator provides a modulated signal using a symbol constellation having at least eight symbols, each symbol associated with at least three bits, where at least one of the three bits has less reliability than the remaining bits; and a mapper maps the at least one data bit to those bit positions of a symbol having higher reliability than the at least one bit position having less reliability and maps the second parity bit to the at least one bit position having less reliability.

In an illustrative embodiment of the invention, the parallel concatenated gallager code encoder comprises a parallel arrangement of at least two low density parity check encoders, where at least one low density parity encoder provides the first parity bit and the other low density parity check encoders provides the second parity bit and the symbol constellation is an 8-phase shift keying symbol constellation.

In another illustrative embodiment of the invention, the parallel concatenated gallager code encoder comprises a parallel arrangement of at least two low density parity check encoders, where at least one low density parity encoder provides the first parity bit and the other low density parity check encoders provides the second parity bit and the symbol constellation is a 16-quadrature amplitude modulation symbol constellation.

In another illustrative embodiment of the invention, the parallel concatenated gallager code encoder comprises a parallel arrangement of at least two low density parity check encoders, where at least one low density parity encoder provides the first parity bit and the other low density parity check encoders provides the second parity bit and the symbol constellation is a 64-quadrature amplitude modulation symbol constellation.

In view of the above, and as will be apparent from reading the detailed description, other embodiments and features are also possible and fall within the principles of the invention.

### BRIEF DESCRIPTION OF THE DRAWINGS

FIG. 1 shows a prior art Parallel Concatenated Gallager Codes (PCGC) encoder;

FIG. 2 shows a prior art Parallel Concatenated Gallager Codes (PCGC) decoder;

FIG. 3 shows another prior art Parallel Concatenated Gallager Codes (PCGC) encoder;

FIG. 4 shows another prior art Parallel Concatenated Gallager Codes (PCGC) decoder;

FIG. 5 shows a prior art 8-PSK Gray mapped symbol constellation;

FIG. 6 shows an illustrative high-level block diagram of an apparatus embodying the principles of the invention;

FIG. 7 shows an illustrative symbol mapper in accordance with the principles of the invention;

FIG. 8 shows another illustrative symbol mapper in accordance with the principles of the invention;

FIG. 9 shows a simulated Bit Error Rate (BER) performance for the mappers of FIGs. 7 and 8;

FIG. 10 shows an illustrative 16 QAM Gray mapped symbol constellation and a mapping in accordance with the principles of the invention;

FIG. 11 shows an illustrative 64 QAM Gray mapped symbol constellation and a mapping in accordance with the principles of the invention;

FIG. 12 shows an illustrative flow chart in accordance with the principles of the invention; and

FIGs. 13-16 show other illustrative embodiments of a receiver in accordance with the principles of the invention.

### DETAILED DESCRIPTION

Other than the inventive concept, the elements shown in the figures are well known and will not be described in detail. For example, other than the inventive concept, familiarity with Discrete Multitone (DMT) transmission (also referred to as Orthogonal Frequency Division Multiplexing (OFDM) or Coded Orthogonal Frequency Division Multiplexing (COFDM)) is assumed and not described herein. Also, familiarity with television broadcasting, receivers and video encoding is assumed and is not described in detail herein. For example, other than the inventive concept, familiarity with current and proposed recommendations for TV standards such as NTSC (National Television Systems Committee), PAL (Phase Alternation Lines), SECAM (SEquential Couleur Avec Memoire), ATSC (Advanced Television Systems Committee) (ATSC), Digital Video Broadcasting (DVB), Digital Video Broadcasting-Terrestrial (DVB-T) (e.g., see ETSI EN 300 744 V1.4.1 (2001-01), *Digital Video Broadcasting (DV8); Framing structure, channel coding and modulation for digital terrestrial television* and the Chinese Digital Television System (GB) 20600-2006 (Digital Multimedia Broadcasting - Terrestrial / Handheld (DMB-T/H)) is assumed. Likewise, other than the inventive concept, other transmission concepts such as eight-level vestigial sideband (8-VSB), Phase-Shift Keying (PSK), Quadrature Amplitude Modulation (QAM), and receiver components such as a radio-frequency (RF) front-end, or receiver section, such as a low noise block, tuners, and down converters; along with fast fourier transform (FFT) elements, spectrum shifters, channel state information (CSI) estimators, equalizers, demodulators, correlators, leak integrators and squarers is assumed. Further, other than the inventive concept, familiarity with processing signals, such as forming channel state information, is assumed and not described herein. Similarly, other than the inventive concept, formatting and encoding methods (such as Moving Picture Expert Group (MPEG)-2 Systems Standard (ISO/IEC 13818-1)) for generating transport bit streams are well-known and not described herein. It should also be noted that the inventive concept may be implemented using conventional programming techniques, which, as such, will not be described herein. In this regard, the embodiments described herein may be implemented in the analog or digital domains. Finally, like-numbers on the figures represent similar elements.

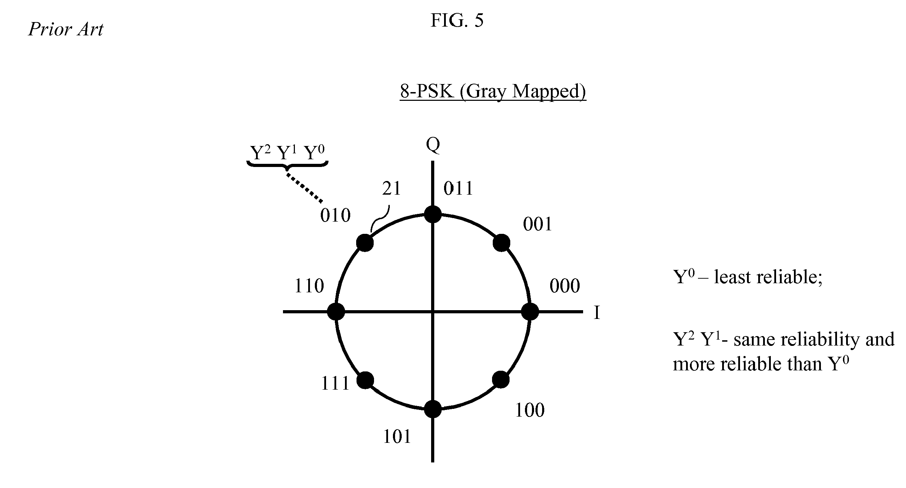

Turning now to FIG. 5, a prior art 8-PSK (Phase Shift Keying) Gray mapped symbol constellation is shown, the x-axis representing the in-phase (I) values and the y-axis representing the quadrature (Q) values. In 8-PSK, the symbol constellation comprises 8 symbols, each symbol representing three bits, shown as Y²Y¹Y⁰ in FIG. 5. For example, as illustrated by the dotted line, the symbol 21 represents the bits pattern 010, where Y²=0, Y¹=1, and Y⁰=0, with Y⁰ being the least significant bit position. As known in the art, in a Gray mapped symbol constellation, adjacent symbols differ in only one bit position. It is also known that different bits positions in a symbol have different reliabilities. For the 8-PSK symbol constellation of FIG. 5, Y⁰ is the least reliable, while Y¹ and Y² have the same reliability and are more reliable that Y⁰ (e.g., see "Reliability-Based Coded Modulation with Low-Density Parity-Check Codes", by Robert D. Maddock and Amir H. Banihashemi; IEEE Transactions on Communications, Vol. 54, No. 3, March 2006).

Since the need for more and more channel capacity is increasing in today's communications systems, the design of a channel code is often required to use a high order modulation. In this regard, we have observed that one can match PCGC LDPC coding to a higher order modulation by taking into account the different bit reliabilities in the associated symbol constellation and get very good performance along with high spectrum efficiency.

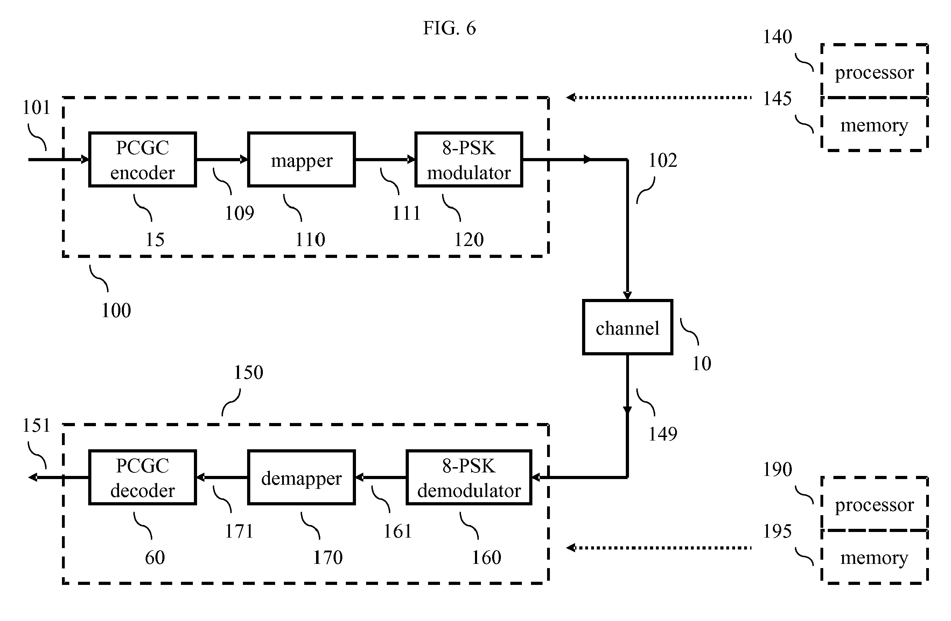

Referring now to FIG. 6, a high-level block diagram of a system in accordance with the principles of the invention is shown comprising a transmitter 100 and a receiver 150. The transmitter 100 transmits (or broadcasts) a signal 102 over a communications channel 10 to receiver 150. Since communications channel 10 affects the transmitted signal, e.g., noise, etc., this results in a signal 149 being received by receiver 150. Communications channel 10 represents wireless or wired communications channels. For purposes of this description, channel 10 represents an AWGN (Additive White Gaussian Noise) channel, though the invention is not so limited.

Transmitter 100 comprises PCGC encoder 15 (as described above with respect to FIG. 1), a mapper 110 and 8-PSK modulator 120. Transmitter 100 is a processor-based system and includes one, or more, processors and associated memory as represented by processor 140 and memory 145 shown in the form of dashed boxes in FIG. 6. In this context, computer programs, or software, are stored in memory 145 for execution by processor 140 and, e.g., implement PCGC encoder 15. Processor 140 is representative of one, or more, stored-program control processors and these do not have to be dedicated to the transmitter function, e.g., processor 140 may also control other functions of transmitter 100. Memory 145 is representative of any storage device, e.g., random-access memory (RAM), read-only memory (ROM), etc.; may be internal and/or external to transmitter 100; and is volatile and/or non-volatile as necessary.

Receiver 150 comprises 8-PSK demodulator 160, demapper 170 and PCGC decoder 60 (as described above with respect to FIG. 2). Like transmitter 100, receiver 150 is also a processor-based system and includes one, or more, processors and associated memory as represented by processor 190 and memory 195 shown in the form of dashed boxes in FIG. 6. In this context, computer programs, or software, are stored in memory 195 for execution by processor 190 and, e.g., implement PCGC decoder 60. Processor 190 is representative of one, or more, stored-program control processors and these do not have to be dedicated to the receiver function, e.g., processor 190 may also control other functions of receiver 150. Memory 195 is representative of any storage device, e.g., random-access memory (RAM), read-only memory (ROM), etc.; may be internal and/or external to receiver 150; and is volatile and/or non-volatile as necessary.

Returning to transmitter 100, data, as represented by input signal 101 (e.g., "X" from FIG. 1), is applied to PCGC encoder 15, which provides three bits representing a PCGC encoded signal 109. In accordance with the principles of the invention, mapper 110 maps the PCGC encoded signal 109 to symbols of an 8-PSK symbol constellation (as shown in FIG. 5) such that 8-PSK modulator 120 selects the appropriate symbols for providing an 8-PSK modulated signal for transmission via signal 102.

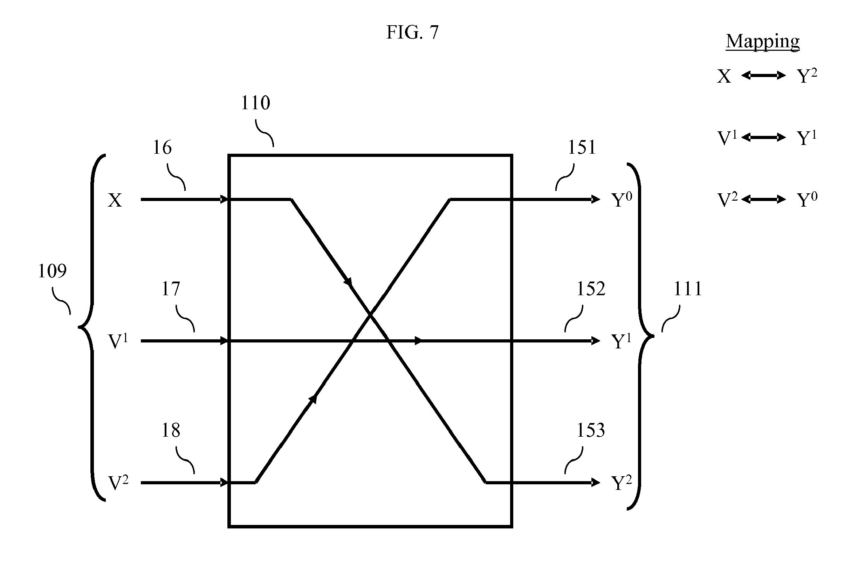

Referring now to FIG. 7, an illustrative mapper 110 for mapping PCGC encoded bits to an 8-PSK symbol constellation (such as that shown in FIG. 5) in accordance with the principles of the invention is shown. As described earlier, the output of PCGC encoder 15 is the systemic information bits X (16), and parity bits V¹ (17) and V² (18). Mapper 110 maps the PCGC LDPC encoded signal 109 taking into account the different bit reliabilities in the associated 8-PSK symbol constellation of FIG. 5. In particular, and as can be observed from FIG. 7 (with reference back to FIG. 5), mapper 110 maps the systemic information bit X (16) and parity bit V¹ (17) to the more reliable positions in the 8-PSK symbol constellation, i.e., Y² (153) and Y¹ (152), respectively. The parity bit V² (18) is mapped to the less reliable bit position Y⁰ (151). Signals 151, 152 and 153 comprise mapper output signal 111, which is applied to 8-PSK modulator 120 for use in selecting the symbols from the symbol constellation. Thus, the systemic information, X, and the parity bits V¹ (representing the error code with better error performance) are matched to the more reliable bit position of the symbol constellation.

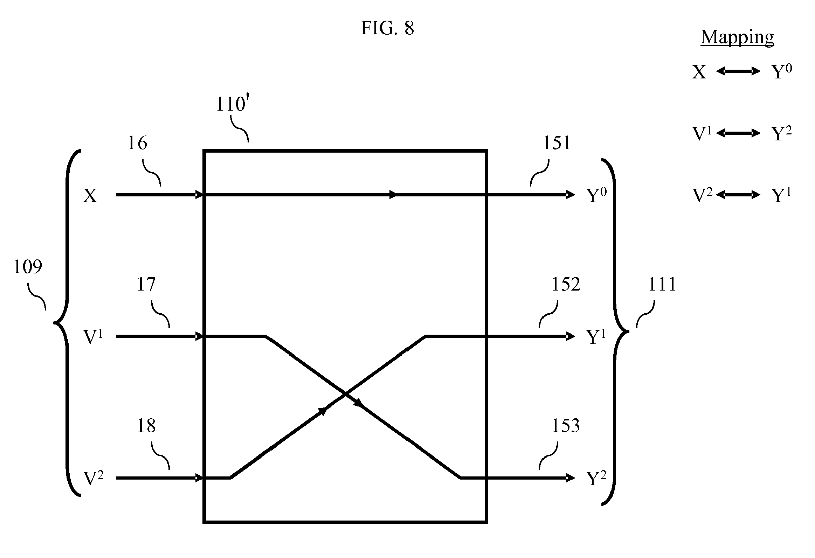

As described above, a PCGC encoder is mapped to a symbol constellation in such a way as to take advantage of the different bit reliabilities of a symbol constellation. This is further illustrated in a different embodiment of mapper 110 shown in FIG. 8 as mapper 110'. Here, mapper 110' maps the systemic information bit X (16) to the less reliable bit position Y⁰ (151). The parity bits V¹ (17) and V² (18) are mapped to the more reliable positions - Y² (153) and Y¹ (152), respectively.

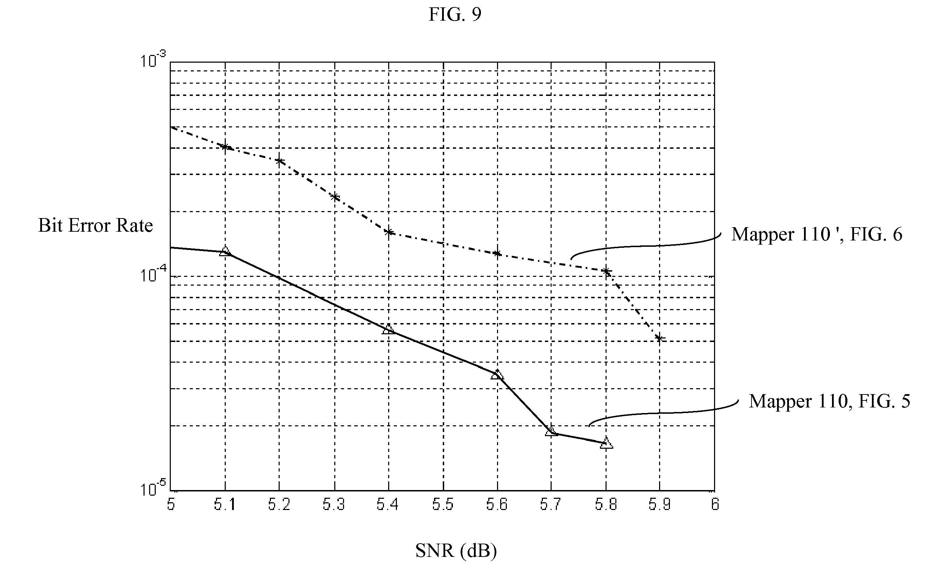

Referring now to FIG. 9, a performance comparison of the simulated bit error rates (BERs) for communications systems using mapper 110 and mapper 110' is shown. It can be observed from FIG. 9 that by taking into account the bit reliabilities of the symbol constellation a further improvement in BER performance can be achieved as shown by the use of mapper 110 of FIG. 7.

It should be noted that the above description of the inventive concept applies also to the case where interleaving is used, i.e., the systemic information bit X (16), and parity bit V¹ (17) and V² (18) are first interleaved as shown in FIG. 3.

Turning back now to FIG. 6, signal 149 is received by 8-PSK demodulator 160 of receiver 150. 8-PSK demodulator 160 provides corresponding received bits Y_{R}²Y_{R}¹Y_{R}⁰ to demapper 170 (via signal 161). Demapper 170 performs a complementary function to that of mapper 110 to provide received versions of PCGC encoded bits X, V1 and V2, i.e., X_{R}, V_{R}¹ and V_{R}² to PCGC decoder 60 (via signal 171). In particular, demapper 170 provides the received versions of transmitted bits X, V¹ and V² as represented by LLR (log likelihood ratios) L_{CH}⁰, L_{CH}¹ and L_{CH}², respectively. As known in the art, demapper 170 makes hard decisions as to the received symbol, i.e., selecting that constellation symbol that is closest in Euclidean distance to the received signal point. PCGC decoder 60 functions as described earlier and provides received error corrected systemic data 151.

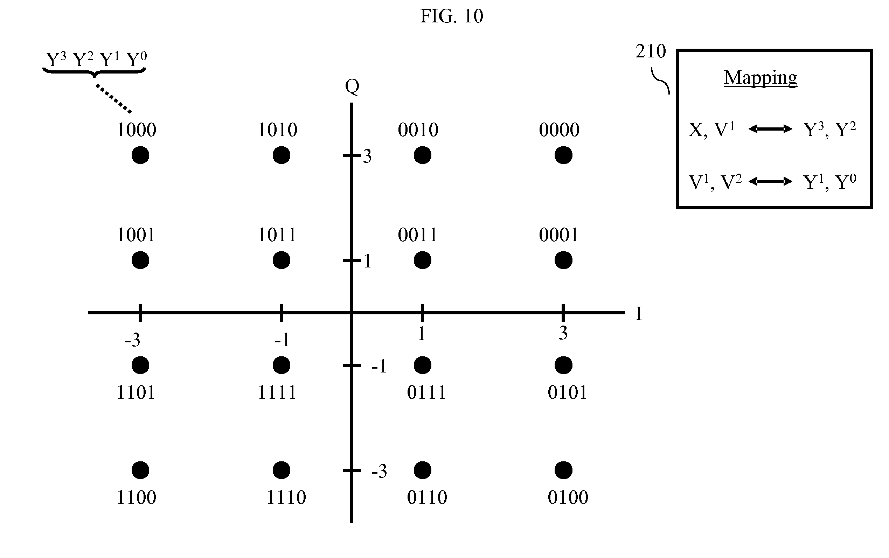

It should be noted that the inventive concept is applicable to other types of higher order modulations. FIG. 10 shows an illustrative 16 Quadrature Amplitude Modulation (QAM) symbol constellation, Gray mapped, and a mapping 210 in accordance with the principles of the invention. In a 16-QAM symbol constellation as shown in FIG. 10, Y⁰ and Y¹ are the least reliable bit positions, and the bit positions Y² and Y³ have the same higher reliability as compared to bit positions Y⁰ and Y¹. In mapping 210, the parity bits generated by the second component V² and a part of V¹ are mapped into the least reliable position Y⁰ and Y¹. The remaining part of V¹ and all of the systematic information bits X are mapped into Y², Y³. Thus, similar to the 8-PSK mapping described above, mapping 210 ensures that all the systematic information bits are mapped to the higher reliability bit position in one constellation symbol and a number of the parity bits V¹ are also mapped to the high reliability bit position. In particular, when bits X, V¹ and V² are mapped into the symbol constellation, consecutive bit-mapping is used. For example, if LDPC encoder 35 is code rate 1/2, (n.k)=(800,400), then X=400, V¹=400; and if LDPC encoder 40 is also code rate 1/2, (n.k)=(800,400), then V²=400. As a result, the overall coderate is 1/3 and all the bits are mapped into 300 constellation symbols. The first 300 bits of X are mapped into Y³, then another 100 bits of X are mapped into Y². Then, the first 200 bits of V¹ are mapped into Y² and another 200 bits of V¹ are mapped into Y¹. Finally, the first 100 bits of V² are mapped into Y¹, and the rest of the bits of V² are mapped into Y⁰.

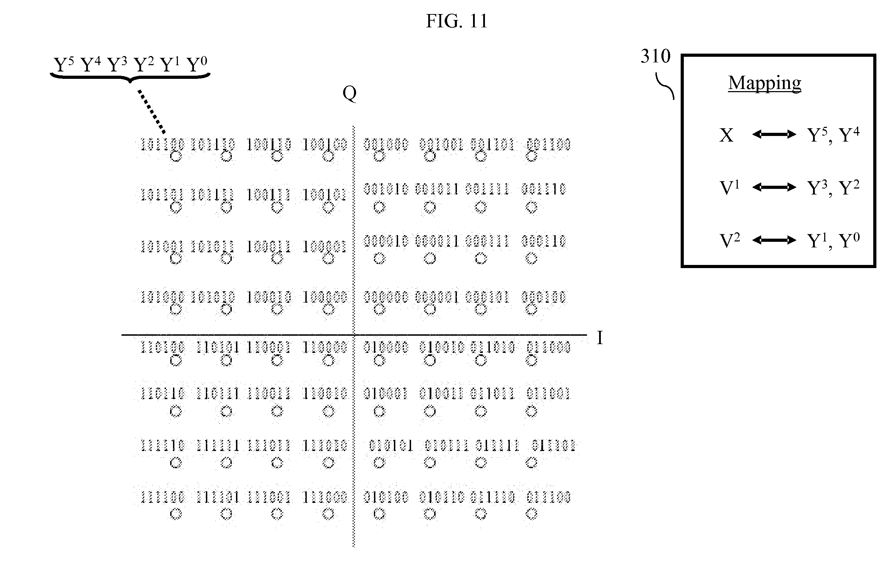

Referring briefly to FIG. 11, this figure shows an illustrative 64 Quadrature Amplitude Modulation (QAM) symbol constellation, Gray mapped, and a mapping 310 in accordance with the principles of the invention. In a 64-QAM symbol constellation as shown in FIG. 10, Y⁰ and Y¹ are the least reliable bit positions, and the bit positions Y⁴ and Y⁵ have the same higher reliability as compared to bit positions Y⁰ and Y¹. In mapping 310, the parity bits generated by the second component V² are mapped into the least reliable position Y⁰ and Y¹. The parity bits generated by the first component V¹ are mapped into Y² and Y³. Finally, the systemic information, X, is mapped into Y⁴ and Y⁵. Thus, similar to the 8-PSK mapping described above, mapping 310 ensures that all the systematic information bits are mapped to the higher reliability bit position in one constellation symbol.

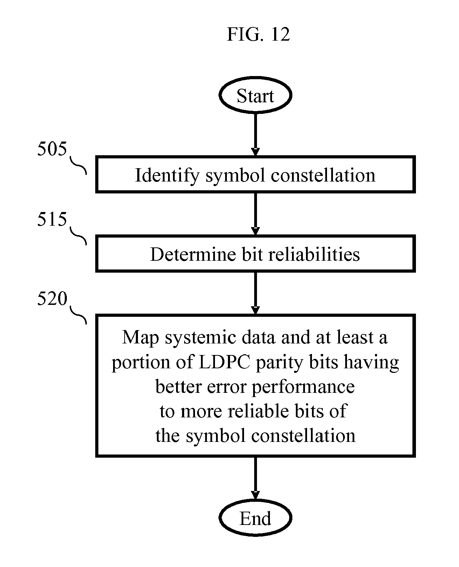

Turning now to FIG. 12, an illustrative flow chart in accordance with the principles of the invention is shown. In step 505, a symbol constellation is identified, e.g., the 8-PSK symbol constellation of FIG. 5 or the 16-QAM symbol constellation of FIG. 10. In step 515, the bit reliabilities for the identified symbol constellation is determined for at least identifying those bits that are least reliable and those bits that are more reliable. In step 520, the systemic data and at least a portion of the LDPC parity bits having better error performance are mapped to the more reliable bit positions of the identified symbol constellation. Thus, the systematic information bits and the parity bits generated by those component LDPC codes that have more strong correcting capability are mapped to the higher reliability bit positions in one constellation symbol. As such, in a corresponding receiver, the decoding of received systematic information bits will have higher reliability and this also helps the convergence of PCGC decoding.

As described above, and in accordance with the principles of the invention, by carefully choosing the mapping strategy between PCGC encoded bits and constellation symbols the combination between PCGC coding and multilevel modulation can be matched to get very good performance along with high spectrum efficiency and yet have low decoding complexity. Although the inventive concept was described in the context of 8-PSK, 16-QAM and 64-QAM, the invention is not so limited and can be easily extended to other higher order modulations where at least some of the constituent bits of the symbol constellation have different reliability. Further, although the inventive concept was described in the context of two LDPC encoders and two LDPC decoders, the inventive concept is not so limited an more LDPC encoders and decoders can be used.

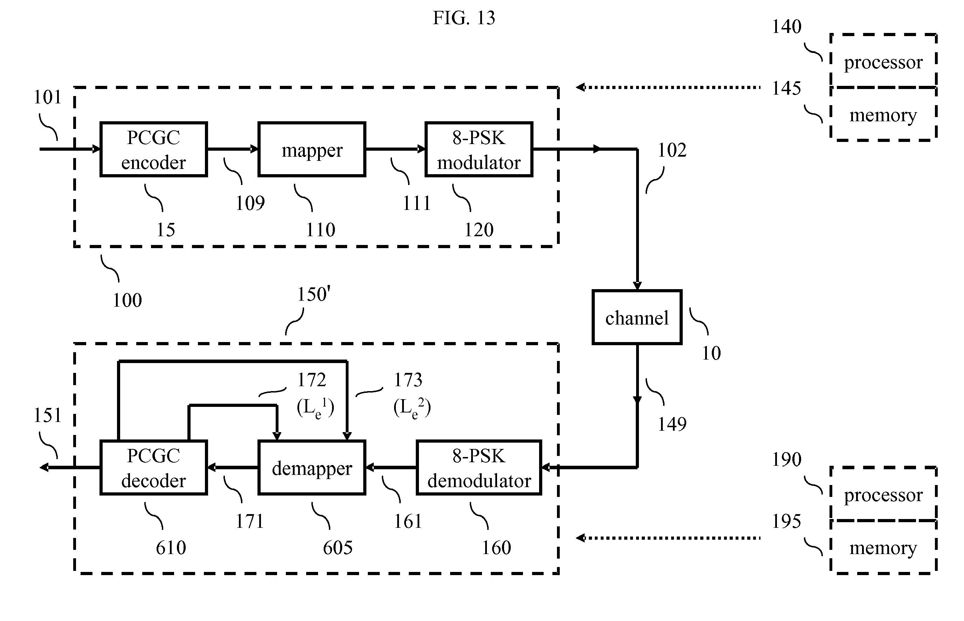

Referring now to FIG. 13 another illustrative receiver in accordance with the principles of the invention is shown. Receiver 150' is similar to receiver 150 described above except for demapper 605 and PCGC decoder 610. Demapper 605 uses LLR information from a previously decoded symbol to improve the selection of the next received symbol by demapper 605. Receiver 150' provides better performance than receiver 150 of FIG. 6. In particular, after the first iteration of PCGC decoder 610, demapper 605 receives LLR values associated with the previously decoded symbol. In this example, demapper 605 receives LLR values Lₑ¹ (172) and Lₑ² (173). Thus, in making hard decisions as to the actual received symbol, demapper 605 now also takes into account information about the reliability of the previously decoded symbol from PCGC decoder 610. The following example illustrates the operation of demapper 605 with respect to Le¹. The operation of demapper 605 with respect to Le² is similar and, as such, is not described herein.

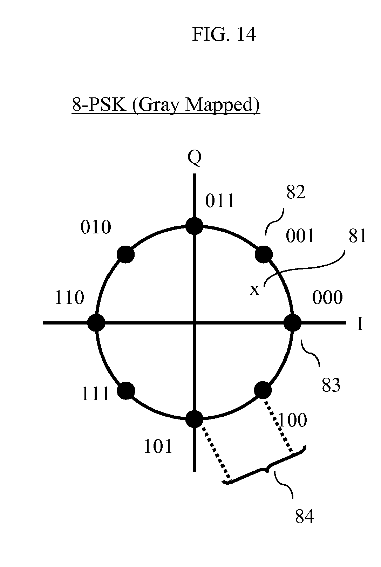

The magnitude of an LLR value represents the confidence in the decoded bits. The larger the LLR magnitude, the higher the confidence in the decoded bit. In this regard, demapper 605 compares the value of Le¹ to a threshold value, *M*. If Le¹ is greater than *M*, then Le¹ represents a binary "1" value. If Le¹ is less than -*M*, then Le¹ represents a binary "0" value. Otherwise, the hard bit decision is uncertain and demapper 605 ignores the value of Le¹ and selects the received symbol based on Euclidean distance. The value for *M* is determined experientially. As noted earlier, in traditional demapping, the constellation symbol closest in Euclidean distance to the received signal point is selected as the received symbol. Referring now to FIG. 14, assume that a received signal point, x (81) is received by receiver 150'. In traditional demapping, either symbol 001 (82) or symbol 000 (83) would be selected by the demapper. However, now, demapper 605 uses the value of Le¹ to improve its decision. For example, if the result of the decision by PCGC decoder 610 shows that the value of Y² Y¹ has a high probability to be "1 0", then demapper 605 selects either symbol 101, or symbol 100 as illustrated by bracket 84 of FIG. 14. It should be noted that the above description also applies to the use of interleaving in the PCGC signal.

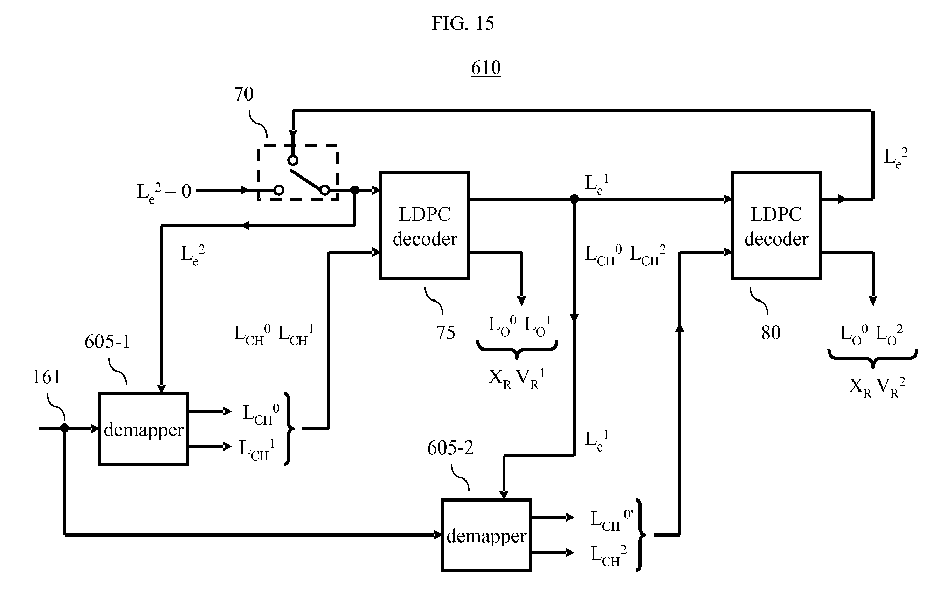

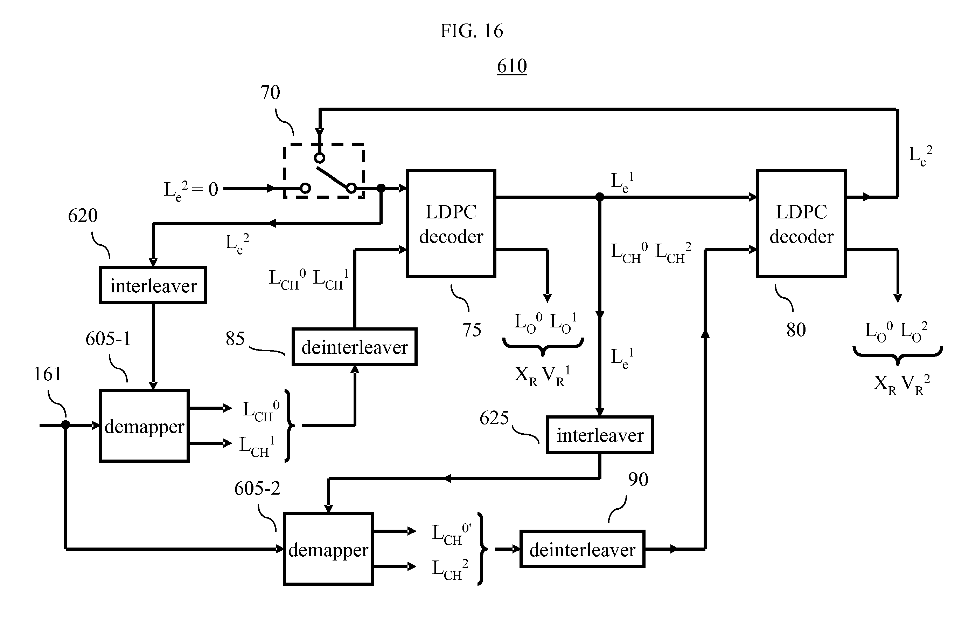

Additional illustrations of the arrangement of decoder 605 and PCGC decoder 610 are shown in FIGs. 15 and 16. FIG. 15 illustrates an arrangement without interleaving; while FIG. 16 illustrates an arrangement with interleaving. As can be observed in FIG. 15, demapper 605 comprises demappers 605-1 and 605-2. Demapper 605-1 uses information (Lₑ¹) from a previously decoded symbol (as described above) for providing L_{CH}⁰ and L_{CH}¹. Likewise, demapper 605-2 uses information (Lₑ²) from a previously decoded symbol for providing L_{CH}^{0'} and L_{CH}², as shown. It should be noted that demapper 605-2 may provide a different L_{CH}⁰ value as represented by L_{CH}^{0'}. FIG. 16 illustrates an arrangement for a system that utilizes interleaving. It should be observed that interleavers 620 and 625 are required to take into account that signal 161 is interleaved.

In view of the above, the foregoing merely illustrates the principles of the invention and it will thus be appreciated that those skilled in the art will be able to devise numerous alternative arrangements which, although not explicitly described herein, embody the principles of the invention and are within its spirit and scope. For example, although illustrated in the context of separate functional elements, these functional elements may be embodied in one, or more, integrated circuits (ICs). Similarly, although shown as separate elements, any or all of the elements (e.g., of FIG. 6) may be implemented in a stored-program-controlled processor, e.g., a digital signal processor, which executes associated software. Further, the principles of the invention are applicable to other types of communications systems, e.g., satellite, Wireless-Fidelity (Wi-Fi), cellular, etc. Indeed, the inventive concept is also applicable to stationary or mobile receivers. It is therefore to be understood that numerous modifications may be made to the illustrative embodiments and that other arrangements may be devised without departing from the spirit and scope of the present invention as defined by the appended claims.

## Claims

1. Apparatus comprising:
a parallel concatenated gallager code encoder for providing at least one data bit, a first parity bit and a second parity bit, where the first parity bit is associated with a low density parity check code having a higher error correcting capability than a low density parity check code associated with the second parity bit;
a modulator for providing a modulated signal using a symbol constellation having at least eight symbols, each symbol associated with at least three bits, where at least one of the three bits has less reliability than the remaining bits; and
a mapper for mapping the at least one data bit to those bit positions of a symbol having higher reliability than the at least one bit position having less reliability and mapping the second parity bit to the at least one bit position having less reliability.

2. The apparatus of claim 1, wherein the mapper maps the first parity bit to those bit positions of a symbol having higher reliability than the at least one bit position having less reliability.

3. The apparatus of claim 1, wherein the parallel concatenated gallager code encoder comprises:
a parallel arrangement of at least two low density parity check encoders, where at least one low density parity encoder provides the first parity bit and the other low density parity check encoders provides the second parity bit.

4. The apparatus of claim 1, wherein the symbol constellation is an 8-phase shift keying symbol constellation.

5. The apparatus of claim 1, wherein the symbol constellation is a 16-quadrature amplitude modulation symbol constellation.

6. The apparatus of claim 1, wherein the symbol constellation is a 64-quadrature amplitude modulation symbol constellation.

7. A method comprising:
encoding data using a parallel concatenated gallager code for providing at least one data bit, a first parity bit and a second parity bit, where the first parity bit is associated with a low density parity check code having a higher error correcting capability than a low density parity check code associated with the second parity bit;
providing a modulated signal using a symbol constellation having at least eight symbols, each symbol associated with at least three bits, where at least one of the three bits has less reliability than the remaining bits; and
mapping (a) the at least one data bit to those bit positions of a symbol having higher reliability than the at least one bit position having less reliability and (b) the second parity bit to the at least one bit position having less reliability.

8. The method of claim 7, wherein the mapping step maps the first parity bit to those bit positions of a symbol having higher reliability than the at least one bit position having less reliability.

9. The method of claim 7, wherein the symbol constellation is an 8-phase shift keying symbol constellation.

10. The method of claim 7, wherein the symbol constellation is a 16-quadrature amplitude modulation symbol constellation.

11. The method of claim 7, wherein the symbol constellation is a 64-quadrature amplitude modulation symbol constellation.
